# EUROPÄISCHE PATENTSCHRIFT

(11) **EP 4 107 118 B1**
(45) Veröffentlichungstag und Bekanntmachung des Hinweises auf die Patenterteilung: **12.08.2026**
(21) Anmeldenummer: 21706212.4
(22) Anmeldetag: 15.02.2021
(51) Int. Cl.: B81C 1/00

(54) **VERFAHREN ZUR HERSTELLUNG EINER NANOSKALIGEN KANALSTRUKTUR**
METHOD FOR PRODUCING A NANOSCALE CHANNEL STRUCTURE
PROCÉDÉ DE FABRICATION D'UNE STRUCTURE DE CANAL D'ÉCHELLE NANOMÉTRIQUE

(30) Priorität: 21.02.2020 DE 102020202262
(43) Veröffentlichungstag der Anmeldung: 28.12.2022
(73) Patentinhaber: Robert Bosch GmbH, 70442 Stuttgart (DE)
(72) Erfinder: SCHELLING, Christoph, 70619 Stuttgart (DE)
(86) Internationale Anmeldenummer: PCT/EP2021/053619
(87) Internationale Veröffentlichungsnummer: WO 2021/165191

(56) Entgegenhaltungen:
- WO-A2-2011/078650
- US-A1- 2008 190 171

## Beschreibung

Die vorliegende Erfindung betrifft ein Verfahren zur Herstellung einer nanoskaligen Kanalstruktur. Des Weiteren betrifft die vorliegende Erfindung ein Computerprogramm, das jeden Schritt des Verfahrens ausführt, sowie ein maschinenlesbares Speichermedium, welches das Computerprogramm speichert. Schließlich betrifft die Erfindung ein elektronisches Steuergerät, welches eingerichtet ist, um das Verfahren auszuführen.

### Stand der Technik

Nanoskalige Kanäle werden für mikrofluidische Anwendungen benötigt. Beispielsweise werden für Genomsequenzierer Nanokanäle eingesetzt, um DNA-Stränge möglichst eng an Ausleseelektroden vorbeizuführen und sie währenddessen zu decodieren. In der Gaschromatographie sind Nanokanäle wegen ihres hohen Oberflächen-zu-Volumen-Verhältnisses bei der Auftrennung von Gasspezies von Vorteil, da die Auftrennung durch die spezifische Wandwechselwirkung geschieht. In beiden Fällen ist die präzise Geometrie des Nanokanals besonders wichtig. Herkömmliche Methoden zur Herstellung nanoskaliger Kanalstrukturen führen jedoch zu nicht gut reproduzierbaren Kanalgeometrien. Dies basiert darauf, dass die Verfahren entweder zeitabhängige Ätzungen beziehungsweise Unterätzungen einsetzen oder der bereits offene Kanal durch eine Schichtabscheidung verschlossen wird, wobei die Wände des Kanals teilweise mitbeschichtet werden. Einige Methoden unterliegen auch starken geometrischen Beschränkungen. Auch Verrundungen bei einer Beschichtung beeinträchtigen die Herstellung nanoskaliger Kanalstrukturen.

Die DE 20 2017 107 858 U1 betrifft eine Vorrichtung für ein Proteinkorona-Sensor-Array zur Früherkennung von Krankheiten. Hierin kann eine Probe durch einen Nanokanal über ein Sensor-Array geleitet werden. Die Kanäle können mittels Opferschichtätzen gebildet werden. Dabei werden lithographische Techniken verwendet, um ein Material auf einem Substrat zu strukturieren. Dieses Material wird durch ein anderes Material unterschiedlicher chemischer Natur bedeckt. Es kann Lithographieprozessen und Ätzprozessen oder anderen Bearbeitungsprozessen unterzogen werden. Das Substrat wird dann einem chemischen Mittel ausgesetzt, das das erste Material selektiv entfernt. Es werden Kanäle in dem zweiten Material gebildet, wobei Hohlräume verbleiben, in denen das erste Material vor dem Ätzprozess vorhanden war. Da die Geometrien des Kanals durch die Lithographie bestimmt werden, können sie auch in diesem Verfahren nicht gut reproduzierbar hergestellt werden.

Das Patentdokument WO 2011/078650 A2 betrifft ein Verfahren zur Herstellung von Nanokanälen, bei dem eine erste Opferschicht so strukturiert wird, dass ein Block mit Seitenwänden entsteht, und dann eine zweite dünne Opferschicht auf diesen Seitenwänden gebildet wird. Die erste Opferschicht wird dann vollständig entfernt und die verbleibenden dünnen vertikalen Pfosten werden als Opferstrukturen für Nanokanäle verwendet, die in einer anschließend aufgebrachten Deckschicht gebildet werden sollen.

### Offenbarung der Erfindung

Ein Verfahren gemäß der Erfindung ist in Anspruch 1 definiert. Weitere Aspekte der Erfindung sind in den unabhängigen Ansprüchen 8-10 definiert.

Das Verfahren zur Herstellung einer nanoskaligen Kanalstruktur umfasst mindestens acht Verfahrensschritte (a bis h):
In einem ersten Verfahrensschritt (Schritt a) wird eine erste Opferschicht auf einem Substrat abgeschieden und strukturiert. Das Substrat kann hierbei sowohl ein Bulkmaterial sein als auch einen Schichtunterbau aufweisen, auf den die erste Opferschicht abgeschieden wird. Diese erste Opferschicht kann auch als "gate layer" bezeichnet werden. Geeignete Abscheidemethoden sind insbesondere chemische Niederdruck-Gasphasenabscheidung (low-pressure chemical vapour deposition; LPCVD) plasmaunterstützte chemische Gasphasenabscheidung (plasma-enhanced chemical vapour deposition; PECVD) oder Atomlagenabscheidung (atomic layer deposition; ALD). Geeignete Materialien der ersten Opferschicht sind insbesondere Silizium oder Siliziumnitrid. Dabei wird eine erste Opferschicht aus polykristallinem Silizium vorzugsweise mittels LPCVD oder ALD abgeschieden und eine erste Opferschicht aus Siliziumnitrid wird vorzugsweise mittels PECVD abgeschieden. Unter Strukturieren wird verstanden, dass die erste Opferschicht bereichsweise vollständig abgetragen wird, sodass das Substrat wieder freiliegt. Die Ränder zwischen der strukturierten ersten Opferschicht und den Bereichen des Substrats, die von der ersten Opferschicht befreit wurden, definieren den Verlauf der nanoskaligen Kanalstruktur.

In einem zweiten Verfahrensschritt (Schritt b) wird eine zweite Opferschicht auf dem Substrat und auf der ersten Opferschicht abgeschieden. Die zweite Opferschicht kann auch als "channel layer" bezeichnet werden. Die Dicke der zweiten Opferschicht definiert die Höhe der nanoskaligen Kanäle. Sie wird daher bevorzugt mit einer Dicke von weniger als 100 nm und besonders bevorzugt mit einer Dicke von weniger als 10 nm abgeschieden. Für das Abscheiden der zweiten Opferschicht sind dieselben Methoden bevorzugt wie für das Abscheiden der ersten Opferschicht. Weiterhin sind für das Abscheiden der zweiten Opferschicht auch dieselben Materialien bevorzugt wie für das Abscheiden der ersten Opferschicht. Besonders bevorzugt werden die erste Opferschicht und die zweite Opferschicht aus demselben Material abgeschieden. Dies ermöglicht ein späteres Entfernen der ersten Opferschicht und der zweiten Opferschicht mittels derselben Methode.

In einem dritten Verfahrensschritt (Schritt c) wird eine Ätzmaskierungsschicht auf der zweiten Opferschicht abgeschieden. Die Ätzmaskierungsschicht kann auch als "spacer layer" bezeichnet werden. Sie kann gegebenenfalls nach dem Abscheiden strukturiert werden. Geeignete Abscheidungsmethoden sind insbesondere PECVD oder ALD. Geeignete Materialien der Ätzmaskierungsschicht sind insbesondere Oxide. Die Dicke der Ätzmaskierungsschicht definiert die Breite der nanoskaligen Kanäle. Sie wird daher mit einer Dicke abgeschieden, die bevorzugt mindestens 1 nm beträgt. Ihre maximale Dicke beträgt bevorzugt weniger als 100 nm, besonders bevorzugt weniger als 20 nm. Hiermit wird eine vorteilhafte Breite für die nanoskalige Kanalstruktur erreicht. Weiterhin ist die Dicke der Ätzmaskierungsschicht bevorzugt geringer als die Dicke der ersten Opferschicht. Besonders bevorzugt ist sie zumindest, um den Faktor 3 geringer als die Dicke der ersten Opferschicht. Ganz besonders bevorzugt ist sie zumindest um den Faktor 30 geringer als die Dicke der ersten Opferschicht. Auf diese Weise wird sichergestellt, dass die Mesastruktur aus erster Opferschicht und zweiter Opferschicht ohne Verrundungen besonders konform beschichtet wird.

In einem vierten Verfahrensschritt (Schritt d) erfolgt ein teilweises Entfernen der Ätzmaskierungsschicht und der zweiten Opferschicht. Eine geeignete Methode zum teilweisen Entfernen der Ätzmaskierungsschicht und der zweiten Opferschicht ist anisotropes Ätzen wie insbesondere reaktives Ionenätzen (reactive ion etching; RIE). Wenn in diesem Verfahrensschritt ein Rückätzen der auf der ersten Opferschicht aufgebrachten Ätzmaskierungsschicht und der auf der ersten Opferschicht aufgebrachten zweiten Opferschicht erfolgt, so wird auch die auf dem Substrat aufgebrachte zweite Opferschicht und die darauf aufgebrachte Ätzmaskierungsschicht überwiegend zurückgeätzt. Lediglich dort, wo die Seitenflächen der ersten Opferschicht von der zweiten Opferschicht und der Ätzmaskierungsschicht bedeckt sind, werden die zweite Opferschicht und die Ätzmaskierungsschicht nicht vollständig zurückgeätzt.

In einem fünften Verfahrensschritt (Schritt e) erfolgt ein Entfernen der ersten Opferschicht und ein weiteres teilweises Entfernen der zweiten Opferschicht. Dies kann vorzugsweise mittels derselben Methode wie das Entfernen der Schichten im Schritt d erfolgen, insbesondere dann, wenn die erste Opferschicht und die zweite Opferschicht aus demselben Material bestehen. Hierdurch bleiben lediglich ein Rest der zweiten Opferschicht in der Breite der geplanten nanoskaligen Kanalstruktur und ein darauf stehender Rest der Ätzmaskierungsschicht zurück. Die Ätzmaskierungsschicht schützt dabei die darunterliegende zweite Opferschicht in einer Breite, die der Dicke der Ätzmaskierungsschicht und damit der Breite der geplanten Kanalstruktur entspricht.

In einem sechsten Verfahrensschritt (Schritt f) wird eine Wandschicht auf der Ätzmaskierungsschicht und auf dem Substrat abgeschieden. Diese Wandschicht, die auch als "confinement layer" bezeichnet werden kann, bildet die Wände der nanoskaligen Kanalstruktur. Vorzugsweise wird sie aus demselben Material abgeschieden wie die Ätzmaskierungsschicht. Hierdurch können die verbleibenden Reste der Ätzmaskierungsschicht und die Wandschicht zu einer Struktur verschmelzen, die aus demselben Material besteht.

In einem siebten Verfahrensschritt (Schritt g) werden Zugangsöffnungen zur zweiten Opferschicht strukturiert. Dies kann durch ein Strukturieren der Wandschicht erfolgen.

In einem achten Verfahrensschritt (Schritt h) erfolgt ein Entfernen der verbliebenen zweiten Opferschicht im Kanalbereich. Dies kann insbesondere durch isotropes Ätzen beispielsweise mit Xenondifluorid (XeF₂) oder mit Schwefelhexafluorid (SF₆) erfolgen. Diese Substanzen können durch die in Schritt g strukturierten Zugangsöffnungen mit der zweiten Opferschicht in Kontakt gebracht werden.

Auf diese Weise wird eine nanoskalige Kanalstruktur erhalten, die durch die Zugangsöffnungen in der Wandschicht zugänglich ist. Da die Höhe der Kanäle durch die Dicke der zweiten Opferschicht definiert wird und die Breite der Kanäle durch die Dicke der Ätzmaskierungsschicht definiert wird und da die Schichtdicken beim Abscheiden mit sehr hoher Genauigkeit eingestellt werden können, ermöglicht das Verfahren eine sehr gut reproduzierbare massenfertigungstaugliche Herstellung nanoskaliger Kanalstrukturen.

Das Computerprogramm ist eingerichtet, jeden Schritt des Verfahrens durchzuführen, wenn es auf einem Rechengerät oder elektronischen Steuergerät abläuft. Hierzu kann das Rechengerät oder elektronische Steuergerät Vorrichtungen steuern, die Abscheidungs-, Strukturierungs- und Entfernungsschritte des Verfahrens durchführen. Das Computerprogramm ermöglicht die Implementierung unterschiedlicher Ausführungsformen des Verfahrens auf einem Steuergerät einer Herstellungsvorrichtung für nanoskalige Kanalstrukturen, ohne hieran bauliche Veränderungen vornehmen zu müssen. Hierzu ist es auf dem maschinenlesbaren Speichermedium gespeichert.

Durch Aufspielen des Computerprogramms auf ein herkömmliches elektronisches Steuergerät wird das elektronische Steuergerät erhalten, welches eingerichtet ist, um mittels des Verfahrens eine nanoskalige Kanalstruktur herzustellen, wenn es hierfür eine geeignete Herstellungsvorrichtung steuert.

### Kurze Beschreibung der Zeichnungen

Ein Ausführungsbeispiel der Erfindung ist in den Zeichnungen dargestellt und wird in der nachfolgenden Beschreibung näher erläutert.
Figur 1 zeigt eine Querschnittsansicht eines Substrats, auf dem eine erste Opferschicht abgeschieden und strukturiert wurde.
Figur 2 zeigt eine Querschnittsansicht des Substrats gemäß Figur 1, nachdem eine zweite Opferschicht auf dem Substrat und der ersten Opferschicht abgeschieden wurde.
Figur 3 zeigt eine Querschnittsansicht des Substrats gemäß Figur 2, nachdem eine Ätzmaskierungsschicht auf der zweiten Opferschicht abgeschieden wurde.
Figur 4 zeigt eine Querschnittsansicht des Substrats gemäß Figur 3, nachdem die Ätzmaskierungsschicht und die zweite Opferschicht teilweise entfernt wurden.
Figur 5 zeigt eine Querschnittsansicht eines Substrats gemäß Figur 4, nachdem die erste Opferschicht entfernt wurde.
Figur 6 zeigt eine Querschnittsansicht des Substrats gemäß Figur 5, nachdem eine Wandschicht auf der Ätzmaskierungsschicht und auf dem Substrat abgeschieden wurde.

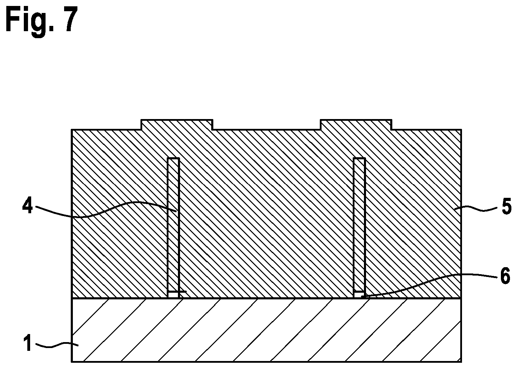

Figur 7 zeigt eine Querschnittsansicht des Substrats gemäß Figur 6 nach Entfernen der zweiten Opferschicht.

### Ausführungsbeispiele der Erfindung

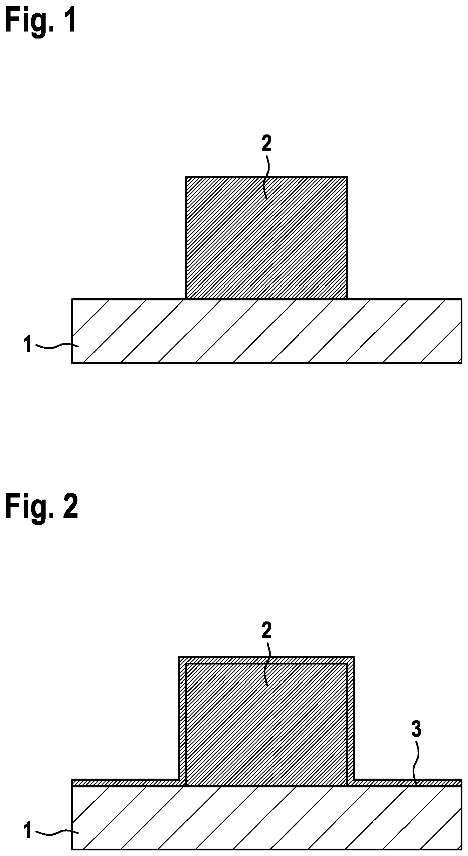

In einem Ausführungsbeispiel der Erfindung wird auf einem Substrat 1 eine erste Opferschicht 2 aus Polysilizium mit einer Dicke von 150 nm abgeschieden. Sie wird so strukturiert, dass das Substrat 1 teilweise wieder freigelegt wird. Dies ist in Figur 1 dargestellt.

Anschließend wird mittels LPCVD eine zweite Opferschicht 3, die ebenfalls aus Polysilizium besteht, so abgeschieden, dass sie die freiliegende Oberfläche des Substrats 1, die Oberfläche der ersten Opferschicht 2 und die Seitenflächen der ersten Opferschicht 2 mit einer Dicke von 5 nm bedeckt. Da die erste Opferschicht 2 und die zweite Opferschicht 3 aus demselben Material bestehen, verschmelzen sie miteinander, wie in Figur 2 dargestellt ist.

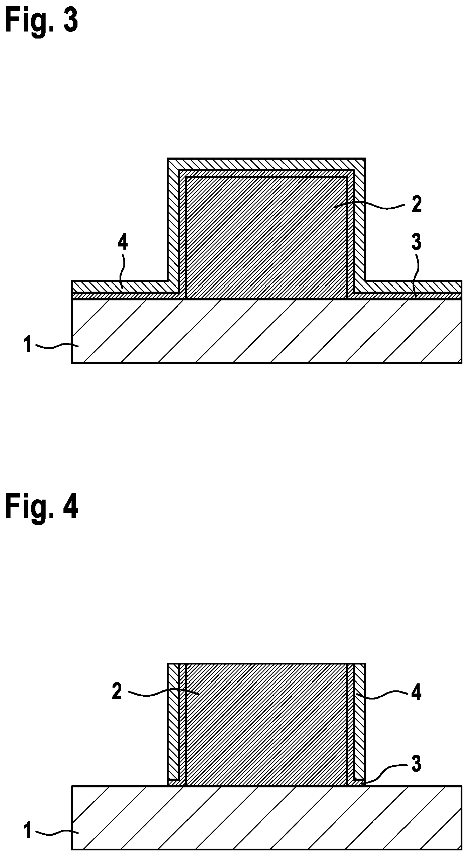

Wie in Figur 3 dargestellt ist, wird daraufhin eine Oxidschicht beispielsweise mittels PECVD so als Ätzmaskierungsschicht 4 abgeschieden, dass sie die Oberfläche und Seitenflächen der 5 nm dicken zweiten Opferschicht 3 mit einer Dicke von 10 nm bedeckt.

Daraufhin erfolgt ein anisotropes RIE-Ätzen als Rückätzen so lange, bis das Substrat 1 teilweise wieder freiliegt. Dies bedeutet, dass in den Bereichen, die nicht von der ersten Opferschicht 2 bedeckt sind, die Ätzmaskierungsschicht 4 und die darunterliegende zweite Opferschicht 3 vollständig entfernt werden. Dabei wird auch die oben auf der ersten Opferschicht 2 aufgebrachte Schichtstruktur aus der zweiten Opferschicht 3 und der Ätzmaskierungsschicht 4 entfernt. Die Teile der Ätzmaskierungsschicht 4, welche die Seiten der ersten Opferschicht 2 bedecken, werden dabei nicht entfernt, da das anisotrope Ätzen lediglich von oben nach unten erfolgt. Diese verbleibenden Teile der Ätzmaskierungsschicht 4 können deshalb den darunterliegenden Teil der zweiten Opferschicht 3 vor dem Rückätzen schützen. Auch die Teile der zweiten Opferschicht 3, die zwischen der ersten Opferschicht 2 und der Ätzmaskierungsschicht 4 angeordnet sind, werden nicht entfernt. Dies ist in Figur 4 dargestellt.

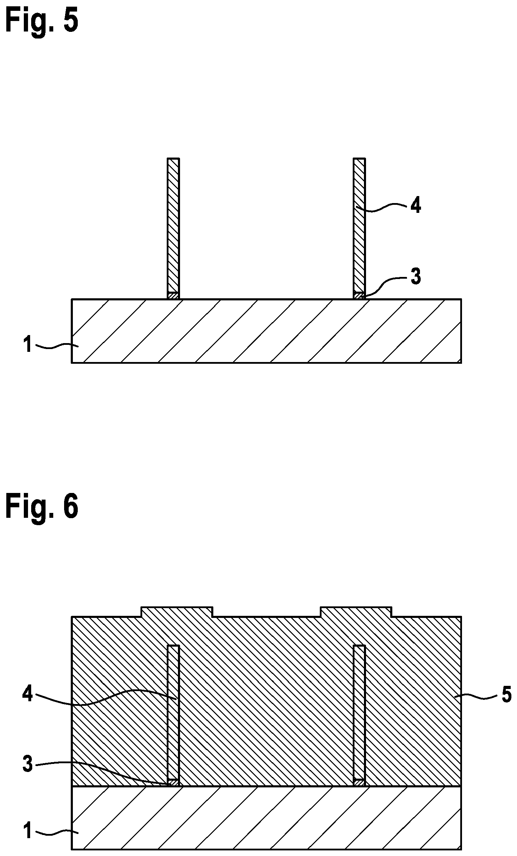

Die Parameter des RIE-Ätzens werden nun so verändert, dass im weiteren Ätzprozess nur noch die erste Opferschicht 2 und die zweite Opferschicht 3, nicht mehr jedoch die Ätzmaskierungsschicht 4 angegriffen wird. Dadurch wird die erste Opferschicht 2 vollständig entfernt, wobei die Reste der Ätzmaskierungsschicht 4 und die davon geschützten Reste der zweiten Opferschicht 3, wie in Figur 5 dargestellt, auf dem Substrat 1 verbleiben.

Es erfolgt nun ein Abscheiden einer Wandschicht 5 beispielsweise aus einem Oxid mittels PECVD in einer Dicke von 200 nm. Wie in Figur 6 dargestellt ist, verschmilzt dabei die Wandschicht 5 mit den Resten der Ätzmaskierungsschicht 4, da diese beiden Schichten aus demselben Material bestehen. Hierdurch kommt es oberhalb der Reste der Ätzmaskierungsschicht 4 zu Vorsprüngen auf der Wandschicht 5. In Figur 6 ist dargestellt, welche Schichtstruktur sich ergibt, wenn diese Vorsprünge bereits durch Strukturierung teilweise geglättet wurden, sodass lediglich ein Hinweis auf der Oberseite der Wandschicht 5 zurückbleibt, wo sich die Reste der zweiten Opferschicht 3 befinden und wo damit in der fertigen Kanalstruktur die nanoskaligen Kanäle verlaufen werden.

Es werden nun Zugangsöffnungen zu den Resten der zweiten Opferschicht 3 strukturiert und durch diese wird so lange XeF₂ eingeleitet, bis die Reste der zweiten Opferschicht 3 durch isotropes Ätzen vollständig entfernt sind. Hierdurch bleiben nanoskalige Kanäle 6 dort zurück, wo sich zuvor die Reste der zweiten Opferschicht 3 befanden. Diese sind durch die Zugangsöffnungen zugänglich. Die Breite der nanoskaligen Kanäle entspricht der vormaligen Dicke der Ätzmaskierungsschicht 4 und damit 10 nm. Die Höhe der nanoskaligen Kanäle entspricht der vormaligen Dicke der zweiten Opferschicht und damit 5 nm. Die auf diese Weise erhaltene nanoskalige Kanalstruktur kann beispielsweise für einen DNA-Sequenzierer oder für einen Gassensor verwendet werden.

## Patentansprüche

1. Verfahren zur Herstellung einer nanoskaligen Kanalstruktur, umfassend die folgenden Schritte:
a) Abscheiden und Strukturieren einer ersten Opferschicht (2) auf einem Substrat (1),
b) Abscheiden einer zweiten Opferschicht (3) auf dem Substrat (1) und auf der ersten Opferschicht (2), wobei die Dicke der zweiten Opferschicht (3) die Höhe der Kanalstruktur definiert,
c) Abscheiden einer Ätzmaskierungsschicht (4) auf der zweiten Opferschicht (3),
d) teilweises Entfernen der Ätzmaskierungsschicht (4) und der zweiten Opferschicht (3) derart, dass die oben auf der ersten Opferschicht (2) aufgebrachte Schichtstruktur aus der zweiten Opferschicht (3) und der Ätzmaskierungsschicht (4) entfernt wird,
jedoch die Teile der Ätzmaskierungsschicht (4), welche die Seiten der ersten Opferschicht (2) bedecken und die Teile der zweiten Opferschicht (3), die zwischen der ersten Opferschicht (2) und der Ätzmaskierungsschicht (4) angeordnet sind, nicht entfernt werden,
e) Entfernen der ersten Opferschicht (2) und weiteres teilweises Entfernen der zweiten Opferschicht (3) derart, dass freiliegende Teile der zweiten Opferschicht (3) entfernt werden und die Reste der Ätzmaskierungsschicht (4) und die davon geschützten Reste der zweiten Opferschicht (3) auf dem Substrat (1) verbleiben,
f) Abscheiden einer Wandschicht (5) auf der Ätzmaskierungsschicht (4) und auf dem Substrat (1),
g) Strukturieren von Zugangsöffnungen zu der zweiten Opferschicht (3), und
h) Entfernen der verbliebenen zweiten Opferschicht (3), sodass eine nanoskalige Kanalstruktur erhalten wird.

2. Verfahren nach Anspruch 1, **dadurch gekennzeichnet, dass** die zweite Opferschicht (3) mit einer Dicke von weniger als 100 nm abgeschieden wird.

3. Verfahren nach Anspruch 1 oder 2, **dadurch gekennzeichnet, dass** die erste Opferschicht (2) und die zweite Opferschicht (3) aus demselben Material abgeschieden werden.

4. Verfahren nach einem der Ansprüche 1 bis 3, **dadurch gekennzeichnet, dass** die Ätzmaskierungsschicht (4) mit einer geringeren Dicke abgeschieden wird, als die erste Opferschicht (2).

5. Verfahren nach einem der Ansprüche 1 bis 4, **dadurch gekennzeichnet, dass** das teilweise Entfernen der Ätzmaskierungsschicht (4) und der zweiten Opferschicht (3) sowie das Entfernen der ersten Opferschicht (2) und das weitere teilweise Entfernen der zweiten Opferschicht (3) durch anisotropes Ätzen erfolgen.

6. Verfahren nach einem der Ansprüche 1 bis 5, **dadurch gekennzeichnet, dass** die Wandschicht (5) aus demselben Material abgeschieden wird, wie die Ätzmaskierungsschicht (4).

7. Verfahren nach einem der Ansprüche 1 bis 6, **dadurch gekennzeichnet, dass** das Entfernen der verbliebenen zweiten Opferschicht (3) durch isotropes Ätzen erfolgt.

8. Elektronisches Steuergerät, welches eingerichtet ist, die Schritte des Verfahrens zur Herstellung einer nanoskaligen Kanalstruktur nach einem der Ansprüche 1 bis 7 in einer entsprechenden Herstellungsvorrichtung auszuführen und/oder anzusteuern.

9. Computerprogramm, insbesondere ablaufend auf einem Rechengerät und/oder einem elektronischen Steuergerät nach Anspruch 8, welches eingerichtet ist, die Schritte des Verfahrens nach einem der Ansprüche 1 bis 7 in einer entsprechenden Herstellungsvorrichtung durchzuführen und/oder anzusteuern.

10. Maschinenlesbares Speichermedium, auf welchem ein Computerprogramm nach Anspruch 9 gespeichert ist.

## Claims

1. Method for producing a nanoscale channel structure, comprising the following steps:
a) depositing and structuring a first sacrificial layer (2) on a substrate (1),
b) depositing a second sacrificial layer (3) on the substrate (1) and on the first sacrificial layer (2), the thickness of the second sacrificial layer (3) defining the height of the channel structure,
c) depositing an etch masking layer (4) on the second sacrificial layer (3),
d) partially removing the etch masking layer (4) and the second sacrificial layer (3) in such a way that the layer structure applied on top of the first sacrificial layer (2) and composed of the second sacrificial layer (3) and the etch masking layer (4) is removed,
but the parts of the etch masking layer (4) which cover the sides of the first sacrificial layer (2) and the parts of the second sacrificial layer (3) which are arranged between the first sacrificial layer (2) and the etch masking layer (4) are not removed,
e) removing the first sacrificial layer (2) and further partially removing the second sacrificial layer (3) in such a way that exposed parts of the second sacrificial layer (3) are removed and the residues of the etch masking layer (4) and the residues of the second sacrificial layer (3) that are protected thereby remain on the substrate (1),
f) depositing a wall layer (5) on the etch masking layer (4) and on the substrate (1),
g) structuring access openings to the second sacrificial layer (3), and
h) removing the remaining second sacrificial layer (3) so that a nanoscale channel structure is obtained.

2. Method according to Claim 1, **characterized in that** the second sacrificial layer (3) is deposited with a thickness of less than 100 nm.

3. Method according to Claim 1 or 2, **characterized in that** the first sacrificial layer (2) and the second sacrificial layer (3) are deposited from the same material.

4. Method according to any of Claims 1 to 3, **characterized in that** the etch masking layer (4) is deposited with a smaller thickness than the first sacrificial layer (2).

5. Method according to any of Claims 1 to 4, **characterized in that** partially removing the etch masking layer (4) and the second sacrificial layer (3) and also removing the first sacrificial layer (2) and further partially removing the second sacrificial layer (3) are effected by anisotropic etching.

6. Method according to any of Claims 1 to 5, **characterized in that** the wall layer (5) is deposited from the same material as the etch masking layer (4).

7. Method according to any of Claims 1 to 6, **characterized in that** removing the remaining second sacrificial layer (3) is effected by isotropic etching.

8. Electronic control unit configured to carry out and/or control the steps of the method for producing a nanoscale channel structure according to any of Claims 1 to 7 in a corresponding production apparatus.

9. Computer program, in particular running on a computing device and/or an electronic control unit according to Claim 8, which is configured to carry out and/or control the steps of the method according to any of Claims 1 to 7 in a corresponding production apparatus.

10. Machine-readable storage medium on which a computer program according to Claim 9 is stored.

## Revendications

1. Procédé de fabrication d'une structure de canal d'échelle nanométrique, comprenant les étapes suivantes :
a) déposer et structurer une première couche sacrificielle (2) sur un substrat (1),
b) déposer une seconde couche sacrificielle (3) sur le substrat (1) et sur la première couche sacrificielle (2), l'épaisseur de la seconde couche sacrificielle (3) définissant la hauteur de la structure de canal,
c) déposer une couche de masquage de gravure (4) sur la seconde couche sacrificielle (3),
d) enlever partiellement la couche de masquage de gravure (4) et la seconde couche sacrificielle (3) de manière à enlever la structure de couches, constituée de la seconde couche sacrificielle (3) et de la couche de masquage de gravure (4), déposée sur le dessus de la première couche sacrificielle (2), les parties de la couche de masquage de gravure (4) qui recouvrent les flancs de la première couche sacrificielle (2) et les parties de la seconde couche sacrificielle (3) disposées entre la première couche sacrificielle (2) et la couche de masquage de gravure (4) n'étant cependant pas enlevées,
e) enlever la première couche sacrificielle (2) et enlever partiellement de manière supplémentaire la seconde couche sacrificielle (3) de telle sorte que les parties exposées de la seconde couche sacrificielle (3) soient enlevées et que les restes de la couche de masquage de gravure (4) et les restes de la seconde couche sacrificielle (3) protégés par ceux-ci restent sur le substrat (1),
f) déposer une couche de paroi (5) sur la couche de masquage de gravure (4) et sur le substrat (1),
g) structurer des ouvertures d'accès à la seconde couche sacrificielle (3), et
h) enlever la seconde couche sacrificielle (3) restante de sorte qu'une structure de canal d'échelle nanométrique soit obtenue.

2. Procédé selon la revendication 1, **caractérisé en ce que** la seconde couche sacrificielle (3) est déposée avec une épaisseur inférieure à 100 nm.

3. Procédé selon la revendication 1 ou 2, **caractérisé en ce que** la première couche sacrificielle (2) et la seconde couche sacrificielle (3) sont déposées à partir du même matériau.

4. Procédé selon l'une quelconque des revendications 1 à 3, **caractérisé en ce que** la couche de masquage de gravure (4) est déposée avec une épaisseur inférieure à celle de la première couche sacrificielle (2).

5. Procédé selon l'une quelconque des revendications 1 à 4, **caractérisé en ce que** l'enlèvement partiel de la couche de masquage de gravure (4) et de la seconde couche sacrificielle (3), ainsi que l'enlèvement de la première couche sacrificielle (2) et l'enlèvement partiel supplémentaire de la seconde couche sacrificielle (3), sont effectués par gravure anisotrope.

6. Procédé selon l'une quelconque des revendications 1 à 5, **caractérisé en ce que** la couche de paroi (5) est déposée à partir du même matériau que la couche de masquage de gravure (4).

7. Procédé selon l'une quelconque des revendications 1 à 6, **caractérisé en ce que** l'enlèvement de la seconde couche sacrificielle (3) restante est effectué par gravure isotrope.

8. Appareil de commande électronique conçu pour effectuer et/ou piloter les étapes du procédé de fabrication d'une structure de canal d'échelle nanométrique selon l'une quelconque des revendications 1 à 7 dans un dispositif de fabrication correspondant.

9. Programme informatique, s'exécutant en particulier sur un appareil de calcul et/ou un appareil de commande électronique selon la revendication 8, qui est conçu pour mettre en œuvre et/ou piloter les étapes du procédé selon l'une quelconque des revendications 1 à 7 dans un dispositif de fabrication correspondant.

10. Support de stockage lisible par machine sur lequel est stocké un programme informatique selon la revendication 9.
